# EUROPEAN PATENT SPECIFICATION

(11) **EP 2 187 461 B1**
(45) Date of publication and mention of the grant of the patent: **29.03.2017**
(21) Application number: 08792424.7
(22) Date of filing: 12.08.2008
(51) Int. Cl.: H01L 35/34, H01L 35/16, H02N 11/00

(54) **PROCESS FOR PRODUCING FINE THERMOELECTRIC ELEMENT**
PROZESS ZUM HERSTELLEN EINES FEINEN THERMOELEKTRISCHEN ELEMENTS
PROCÉDÉ POUR PRODUIRE UN ÉLÉMENT THERMOÉLECTRIQUE FIN

(30) Priority: 13.08.2007 JP 2007211167
(43) Date of publication of application: 19.05.2010
(73) Proprietor: National Institute of Advanced Industrial Science and Technology, Tokyo 100-8921 (JP); Sintokogio, Ltd., Nagoya-shi, Aichi 450-0002 (JP)
(72) Inventor: KAGA, Hisashi, Nagoya-shi Aichi 463-8560 (JP); KINEMUCHI, Yoshiaki, Nagoya-shi Aichi 463-8560 (JP); AOKI, Tomohiro, Toyokawa-shi Aichi 442-8505 (JP); ISHIGURO, Hirohide, Toyokawa-shi Aichi 442-8505 (JP)
(74) Representative: V.O.
(86) International application number: PCT/JP2008/064494
(87) International publication number: WO 2009/022698

(56) References cited:
- JP-A- 04 030 585
- JP-A- 06 338 636
- JP-A- 07 190 854
- JP-A- 10 099 955
- JP-A- 2002 158 379
- JP-A- 2002 223 010
- JP-A- 2002 280 624
- JP-A- 2005 159 019
- JP-A- 2006 261 384
- JP-A- 2007 095 897
- US-A1- 2007 175 506

## Description

### TECHNICAL FIELD

The present invention relates to a process for producing a fine thermoelectric element. More particularly, the present invention relates to a process for producing a fine thermoelectric element that makes possible the construction of an integrated circuit of a fine structure (structural unit = 0.01 to 10 mm) comprising a thermoelectric material that has excellent properties and is constituted of crystals oriented in the same direction. The above-mentioned fine structure is useful as a power source, a power source for exhaust heat recovery, or Peltier element.

### BACKGROUND ART

Due to the excellent thermoelectric properties of thermoelectric materials constituted of crystals oriented in the same direction, it has been thought that a power source of small-scale and high power density could be developed by constructing an integrated circuit from a fine structure (structural unit = 0.01 to 10 mm) of such a thermoelectric material. However, the following problems have occurred with the prior art, and it has been difficult to fabricate a structural body having such a fine structure.

As the processes heretofore known for the fabrication of thermoelectric materials, vapor-phase processes, electroplating processes, mechanical processing processes, and melting processes are known. Thermoelectric materials constituted of crystals oriented in the same direction can be obtained by vapor-phase processes, but it is difficult with these processes to obtain film thicknesses of 10 µm or more. This has resulted in the problem of large resistance values for the thermoelectric material and has made it difficult to establish adequate temperature differentials.

According to the electroplating processes, it has been difficult to arrange orientation of the crystals in the same direction, and according to the mechanical processing processes, it has been difficult to micro-fine materials due to the cleavage of the materials. With regard to melting processes, while thermoelectric materials constituted of crystals oriented in the same direction can be obtained by these processes, the adhesion to the substrate is poor and it has been difficult to retain the shape of the thermoelectric materials. US 2007/175506 A1 discloses a method of forming thermoelectric elements whereby molten thermoelectric material is introduced into grooves of a mold and then solidified by cooling to form a plurality of thermoelectric elements.

In order to solve the above-mentioned problems with the melting processes, the prior art provides, for example, a process in which, using a slider boat, the molten raw material is cast into a processed groove processed in a substrate that is covered up by a cover (Patent Reference 1). As a result, a monocrystalline thermoelectric material is formed thereby. However, this type of process has problems with wettability of the substrate with the molten raw material and with the discharge of gas within the processed groove, and it is difficult to cast the molten raw material into the fine processed groove.

In the prior art, a process for causing the molten raw material to tightly contact with the fine holes is proposed, wherein the fine holes are disposed in a silicon substrate by etching, a powder of the raw material is filled into the fine holes, each individual substrate with the raw material is enclosed in a glass capsule, the capsule is softened at high temperature, and the capsule is then pressurized using a gas pressure (Patent Reference 2). This type of process, however, requires a step for removing the capsule and therefore necessitates post-processing due to the risk of reaction between the glass capsule and the thermoelectric material.

In another vein, there exists a process in which a film is formed by using centrifugal force during heating the raw material. For example, a process is provided in the prior art in which a powder of the raw material is placed on the inner surface of a cylindrical metal vessel and is melted while the cylindrical vessel is being rotated to form a coating film that is resistant to corrosion (Patent Reference 3). According to this method, it is possible to form a film of a thermoelectric material, however, the conditions for forming the film here are under an open system and, as a consequence, there exist problems that the desired film composition is not obtained and thereby the thermoelectric properties are weak, due to the different vapor pressures of the molten elements.

In another vein, a process is provided in the prior art in which, for example, a powder or precursor is placed on a substrate and a film is formed by sintering it while applying centrifugal force during the heating of it (Patent Reference 4). However, due to the use of a process of the sintering of it to form the film thereof, it is difficult to obtain material that has a high degree of orientation. This type of process has problems in that it requires a large centrifugal force, which causes the apparatus to become complex.

Thus, a thermoelectric material constituted of crystals oriented in the same direction can be obtained by the prior processes, but it is quite difficult with these processes to obtain fine structures (0.01 to 10 mm) of such a thermoelectric material on a substrate, and there is a strong demand in this field of technology for the development of a novel technology for fabricating thermoelectric elements that would make possible the simple and convenient fabrication of the aforementioned fine structures.

Patent Reference 1: Japanese Patent Application Laid-open No. 2002-223010
Patent Reference 2: Japanese Patent Application Laid-open No. 2003-174202
Patent Reference 3: Japanese Patent Application Laid-open No. 2000-268784
Patent Reference 4: Japanese Patent Application Laid-open No. 2002-193680

Under these circumstances and considering the prior art described above, the present inventors carried out intensive and extensive investigations directed to developing a novel technology for producing a fine thermoelectric element that could provide a thermoelectric material constituted of crystals oriented in the same direction and that would make possible the fabrication on a substrate of a fine structure having a structural unit of 0.01 to 10 mm. The present inventors also sought to develop products from this fine thermoelectric element. As a result of these investigations, the fabrication of a thermoelectric material comprising the aforementioned fine structure and having very tight contact with the substrate was achieved by using a melting and pressurizing method, and this led to the completion of the present invention.

### DISCLOSURE OF THE INVENTION

An object of the present invention is to provide a process for producing a fine thermoelectric element that makes it possible to obtain, on a substrate, a fine structure (structural unit = 0.01 to 10 mm) of a thermoelectric material that is constituted of crystals oriented in the same direction and that exhibits excellent properties.

The present invention is constituted of the following technical means in order to solve the problems identified above.
(1) A method for producing, on a substrate, a fine thermoelectric element having a structural unit of 0.01 to 10 mm composed of a fine structure of a thermoelectric material constituted of crystals oriented in the same direction, the method comprising:
   charging a required amount of a raw material for the thermoelectric material to a processed groove in a substrate;
   placing a lid on the substrate; enclosing the substrate and lid within a sealed vessel to provide a sealed state;
   heating the material at a temperature that is greater than or equal to the melting point of the thermoelectric material and less than its boiling point to cause melting while applying centrifugal force in a direction perpendicular to the direction of the groove bottom of the processed groove-, to bring the molten material into tight contact with the processed groove; and
   cooling the material to obtain a thermoelectric material constituted of crystals oriented in the same direction.
(2) The method for producing a fine thermoelectric element according to the aforementioned (1), wherein the raw material composition for the thermoelectric material comprises Bi and Sb as the main components at the A site and Te and/or Se as the main component at the B site in an A₂B₃ intermetallic compound.
(3) The method for producing a fine thermoelectric element according to the aforementioned (1), wherein a centrifugal acceleration is applied in the range of at least 100 G and not more than 10000 G based on the relationship Y = 316.2X^{-0.5} between the centrifugal acceleration (Y) and the groove width (X) of the processed groove.
(4) The method for producing a fine thermoelectric element according to the aforementioned (1), wherein a p-type semiconductor and an n-type semiconductor are simultaneously produced by adjusting the heating temperature to be suitable for a semiconductor having a higher melting point.

The present invention is described in additional detail in the following.

The present invention is a process for producing, on a substrate, a fine thermoelectric element having a structural unit of 0.01 to 10 mm comprising a fine structure of a thermoelectric material constituted of crystals oriented in the same direction, the process is characterized by charging a required amount of a raw material for the thermoelectric material to a processed groove in a substrate, placing a lid on the substrate, enclosing the substrate and lid within a sealed vessel to provide a sealed state, heating the material at a temperature that is greater than or equal to the melting point of the thermoelectric material and less than its boiling point to cause melting of the raw material while applying centrifugal force in a direction perpendicular to the direction of the groove bottom of the processed, to bring the molten material into tight contact with the processed groove, and then cooling the material to obtain a thermoelectric material constituted of crystals oriented in the same direction.

Described herein is also a fine thermoelectric element produced in a processed groove in a substrate, that characteristically has a raw material composition that provides Bi and Sb as the main components at the A site and Te and/or Se as the main component at the B site in an A₂B₃ intermetallic compound and is a fine structure having a structural unit of 0.01 to 10 mm, and, for example, is characteristically a fine thermoelectric element comprising an oriented Bi-Te system thick film having a crystal structure with a threefold symmetry according to the (015) pole figure and having a power factor of at least 3.0 (mW/mK²).

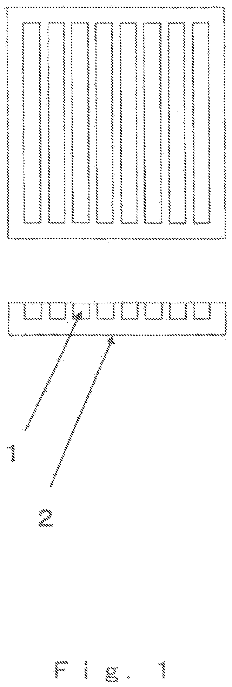

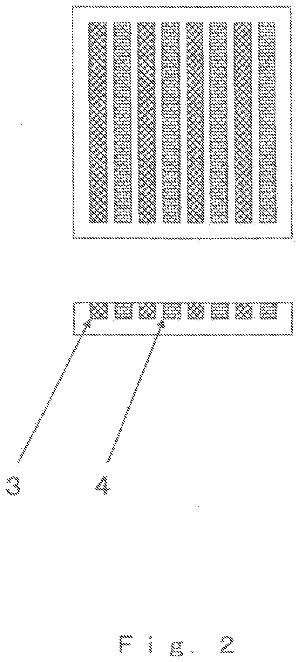

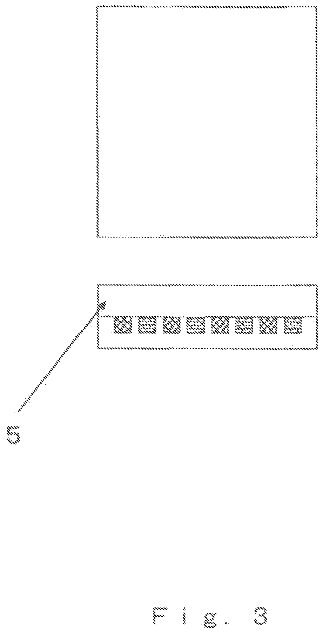

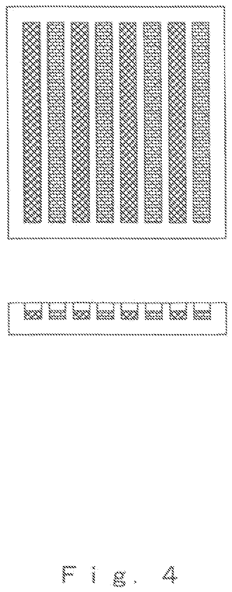

The basic process of the present invention for solving the problems with the conventional melting processes is explained in the following based on FIGS 1 to 4. The substrate (2) is first subjected to fine processing and the required amounts of starting powders for a p-type semiconductor (3) and an n-type semiconductor (4) are charged to the resulting processed grooves (1) (including the processed openings). The substrate is an insulating material, and the insulating material is selected from insulating materials that do not react with the molten material. The composition of the raw material has a composition that contains Bi and Sb as the main components at the A site and Te and/or Se as the main component at the B site in an A₂B₃ intermetallic compound, and the p-type semiconductor (3) and n-type semiconductor (4) are adjusted, for example, by the ratio between Bi and Te or by impurity elements.

In order to inhibit shifts in the composition of the thermoelectric material, a lid (5) is placed on the substrate and the substrate and lid are enclosed in a sealed vessel to provide a sealed state. A sealed vessel is selected such that it does not undergo melting in the neighborhood of the melting point of the thermoelectric material. The thermoelectric material is melted by heating it at a temperature that is greater than or equal to the melting point thereof but less than the boiling point thereof, while applying centrifugal force perpendicular to the direction of the groove bottom of the processed groove in the substrate. The molten material is brought into tight contact with the processed groove in the substrate by the increase in pressure brought about by the centrifugal force. The molten material is cooled, then a fine thermoelectric material constituted of crystals oriented in the same direction can be provided.

A substrate is selected from substrates that do not react with the thermoelectric material. Suitable examples are zirconia, alumina, mica, silica, and so forth. The substrate is subjected to fine processing to form an integrated circuit comprising the processed groove (including the processed opening). There are no particular limitations on the specific structure provided by this fine processing or on the methodology used for the fine processing.

As an example, a starting powder is prepared by weighing out and mixing Bi, Te, Sb, and Se metal powders, each with a purity of at least 99.99%, so as to provide the composition Bi₂₋ₓSbₓTe₃ (0.01 ( x ( 1.5) for the p-type thermoelectric material and the composition Bi_{2-y}Sb_{y}Te_{3-z}Se_{z} (0.01 ( y ( 0.2, 0.01 ( z ( 0.5) for the n-type thermoelectric material.

This starting powder is charged to the processed groove in the finely processed substrate, the groove is covered with a lid and sealed within a sealed vessel. The processed groove in the substrate may be designed and processed freely in correspondence with the intended use. The lid is selected such that it does not react with the thermoelectric material. Substrates of zirconia, alumina, mica, silica, and so forth, are suitable examples, but there is no limitation to these.

As the sealed vessel, wrapping with a metal foil, enclosing in a capsule, and so forth can be exemplified. The metal foil is suitably exemplified by metal foils that do not melt in the neighborhood of the melting point of the thermoelectric material, for example, aluminum foil, nickel foil, zirconium foil, and platinum foil, while the enclosing in a capsule is suitably exemplified by enclosure of capsules that do not melt in the neighborhood of the melting point of the thermoelectric material, for example, of quartz glass, stainless steel, platinum, nickel, graphite, boron nitride, aluminum nitride, and so forth, but there is no limitation to the preceding.

Then, while applying centrifugal force perpendicular to the direction of the groove bottom of the processed groove in the substrate, the thermoelectric material is melted by heating it at a temperature that is greater than or equal to the melting point of the thermoelectric material and less than the boiling point of the thermoelectric material. A centrifugal acceleration is applied that is at least 100 G and not more than 10000 G based on the relationship Y = 316.2X^{-0.5} between the centrifugal acceleration (Y) and the groove width (X) of the processing groove. The heating temperature is suitably at least 615°C when Bi_{0.5}Sb_{1.5}Te₃ powder is used for the p-type thermoelectric material and is suitably at least 600°C when Bi_{1.8}Sb_{0.2}Te_{2.85}Se_{0.15} powder is used for the n-type thermoelectric material; however, the heating temperature is not limited to the preceding since the melting point of the thermoelectric material varies with its composition.

The Te volatilizes in the prior processes in the thermoelectric material melting stage and, as a consequence, the weight of the resulting film is reduced by several tens of wt% from the weight of the starting powder before heating and a reduction in the thermoelectric properties has been observed due to this shift in the composition. In contrast to this, the sealing effect provided by the lid and sealed vessel in the present invention, for example, by inhibiting volatilization of easily volatilized Te from the Bi-Te system thick film, can hold the weight loss for the resulting film to 1 wt% or less and can inhibit the reduction in the thermoelectric properties.

In addition, while the production of thermoelectric material constituted of crystals oriented in the same direction has been possible with prior processes, for example, by vapor-phase processes and melting processes, it has been quite difficult with these processes to produce an integrated circuit with a fine structure (structural unit of 0.01 to 10 mm) of such a thermoelectric material.

In contrast, the present invention obtains and achieves the new knowledge that the use of centrifugal force can solve the drawbacks in the prior melting processes that are poor adhesion to the substrate and difficulty in retaining shape thereof, and has realized the production on a substrate of an integrated circuit using a fine structure (structural unit of 0.01 to 10 mm).

The features of the fine thermoelectric element produced in accordance with a particular embodiment of the method of the present invention are characterized in that it contains Bi and Sb as the main components at the A site and Te and/or Se as the main component at the B site in an A₂B₃ intermetallic compound, that it is a fine structure with a structural unit of 0.01 to 10 mm, that it comprises, for example, a Bi-Te system oriented thick film having a crystalline structure with threefold symmetry according to the (015) pole figure, and that it has a power factor of at least 3.0 mW/mK². Through the sealing effect provided by the lid and sealed vessel, evaporation during heating of the readily volatile Te is inhibited. The inventive process of producing a fine thermoelectric element is not limited to the production of a fine thermoelectric element with the specific composition provided above, and the present invention can be similarly used to produce any useable Te-containing fine structure.

The present invention provides the following effects.
(1) The present invention can provide a simple and convenient technology for producing fine structures, that can form a thermoelectric material into finely and densely patterned grooves with a structural unit of 0.01 to 10 mm, that makes it possible to easily remove the lid and sealed vessel that are used, and that does not require post-processing.
(2) A fine thermoelectric material constituted of crystals oriented in the same direction and exhibiting very good thermoelectric properties can be produced by the method of the present invention, without the appearance of shifts in the composition of the thermoelectric material.
(3) The structure of the apparatus employed in the method can also be simplified because the fine thermoelectric material constituted of crystals oriented in the same direction can be fabricated by a centrifugal acceleration of several 100 G's.

### BRIEF DESCRIPTION OF THE DRAWINGS

FIG 1 is a schematic drawing that shows one example of the substrate having grooves processed therein to be used in the present invention;
FIG 2 is a schematic descriptive drawing that shows one example in which the processed grooves have been filled with p thermoelectric material and n thermoelectric material in alternation;
FIG 3 is a schematic descriptive drawing that shows an example in which a substrate as a lid has been covered on a substrate after the material has been introduced in the substrate;
FIG 4 is a schematic descriptive drawing that shows one example of a thermoelectric element produced in accordance with the present invention;
FIG 5 is a descriptive drawing that shows the relationship between the groove width and the centrifugal acceleration at which a film can be formed or not formed; and FIG 6 is a (015) pole figure of the p-type semiconductor.

### EXPLANATION OF REFERENCE NUMERALS

- 1: processed grooves
- 2: substrate
- 3: p-type semiconductor
- 4: n-type semiconductor
- 5: lid

### BEST MODE FOR CARRYING OUT THE INVENTION

The present invention is specifically described in the following based on examples, but the present invention is in no way limited by the following examples.

### Example 1

### (1) Preparation of starting powders and formation of film

Starting powders were prepared by weighing out and mixing Bi, Te, Sb, and Se metal powders, each with a purity of at least 99.99%, so as to provide the composition Bi₂₋ₓSbₓTe₃ (0.01 ≤ x ≤ 1.5) for the p-type thermoelectric material and the composition Bi_{2-y}Sb_{y}Te_{3-z}Se_{z} (0.01 ≤ y ≤ 0.2, 0.01 ≤ z ≤ 0.5) for the n-type thermoelectric material.

These starting powders were charged to the processed grooves of an alumina (Japan Fine Ceramics Co., Ltd.) or zirconia (ZR-Y from Nikkato Corporation) substrate that had previously been patterned with grooves with a width from 0.001 to 10 mm, the processed grooves were covered by an alumina substrate serving as the lid and further enclosed with aluminum foil, nickel foil, or quartz glass. While applying a centrifugal force of from 0 G to 10000 G to the direction perpendicular to the direction of the groove bottom of the processed grooves in the substrate, the starting powders were heated for 20 minutes at 570°C to 615°C and thereafter cooled to form a film. The experimental conditions and the results for formation of the film are shown in Table 1. It was also confirmed that the same results were obtained in experiments, wherein a zirconia substrate as the lid was employed in place of the said alumina substrate used in the preceding process.

**[Table 1]**

| | type | composition | substrate | sealed vessel | centrifugal acceleration (G) | groove width (mm) | melting temperature (°C) | film formation |
|---|---|---|---|---|---|---|---|---|
| 1 | p | Bi_{0.5}Sb_{1.5}Te₃ | zirconia | aluminum foil | 0 | 1 | 615 | not possible |
| 2 | p | Bi_{0.5}Sb_{1.5}Te₃ | zirconia | aluminum foil | 100 | 1 | 615 | not possible |
| 3 | p | Bi_{0.5}Sb_{1.5}Te₃ | zirconia | aluminum foil | 100 | 10 | 615 | possible |
| 4 | p | Bi_{0.5}Sb_{1.5}Te₃ | zirconia | aluminum foil | 1000 | 0.001 | 615 | not possible |
| 5 | p | Bi_{0.5}Sb_{1.5}Te₃ | zirconia | aluminum foil | 1000 | 0.1 | 615 | possible |
| 6 | p | Bi_{0.5}Sb_{1.5}Te₃ | zirconia | aluminum foil | 1000 | 1 | 615 | possible |
| 7 | p | Bi_{0.5}Sb_{1.5}Te₃ | zirconia | aluminum foil | 10000 | 0.001 | 615 | possible |
| 8 | p | Bi_{0.5}Sb_{1.5}Te₃ | zirconia | aluminum foil | 10000 | 10 | 615 | possible |
| 9 | p | Bi_{0.5}Sb_{1.5}Te₃ | zirconia | aluminum foil | 10000 | 10 | 585 | not possible |
| 10 | p | Bi_{0.5}Sb_{1.5}Te₃ | zirconia | aluminum foil | 10000 | 10 | 600 | not possible |
| 11 | p | Bi_{0.5}Sb_{1.5}Te₃ | zirconia | zirconium foil | 3000 | 3 | 615 | possible |
| 12 | p | Bi_{0.5}Sb_{1.5}Te₃ | zirconia | quartz glass | 3000 | 3 | 615 | possible |
| 13 | p | Bi_{0.5}Sb_{1.5}Te₃ | zirconia | nickel foil | 3000 | 3 | 615 | possible |
| 14 | p | Bi_{0.5}Sb_{1.5}Te₃ | alumina | zirconium foil | 3000 | 3 | 615 | possible |
| 15 | p | Bi_{0.5}Sb_{1.5}Te₃ | alumina | quartz glass | 3000 | 3 | 615 | possible |
| 16 | p | Bi_{0.5}Sb_{1.5}Te₃ | alumina | nickel foil | 3000 | 3 | 615 | possible |
| 17 | p | Bi_{1.0}Sb_{1.0}Te₃ | zirconia | aluminum foil | 3000 | 3 | 615 | possible |
| 18 | p | Bi_{1.8}Sb_{0.2}Te₃ | zirconia | aluminum foil | 3000 | 3 | 615 | possible |
| 19 | p | Bi_{1.99}Sb_{0.01}Te₃ | zirconia | aluminum foil | 3000 | 3 | 615 | possible |
| 20 | n | Bi_{1.5}Sb_{0.2}Te_{2.85}Se_{0.15} | zirconia | aluminum foil | 3000 | 3 | 585 | not possible |
| 21 | n | Bi_{1.5}Sb_{0.2}Te_{2.85}Se_{0.15} | alumina | aluminum foil | 3000 | 3 | 600 | possible |
| 22 | n | Bi_{1.5}Sb_{0.2}Te_{2.85}Se_{0.15} | zirconia | aluminum foil | 3000 | 3 | 600 | possible |
| 23 | n | Bi_{1.9}Sb_{0.1}Te_{2.85}Se_{0.15} | zirconia | aluminum foil | 3000 | 3 | 600 | possible |
| 24 | n | Bi_{1.99}Sb_{0.01}Te_{2.85}Se_{0.15} | zirconia | aluminum foil | 3000 | 3 | 600 | possible |
| 25 | n | Bi_{1.8}Sb_{0.2}Te_{2.75}Se_{0.25} | zirconia | aluminum foil | 3000 | 3 | 600 | possible |
| 26 | n | Bi_{1.9}Sb_{0.1}Te_{2.75}Se_{0.25} | zirconia | aluminum foil | 3000 | 3 | 600 | possible |
| 27 | n | Bi_{1.99}Sb_{0.01}Te_{2.75}Se_{0.25} | zirconia | aluminum foil | 3000 | 3 | 600 | possible |
| 28 | n | Bi_{1.8}Sb_{0.2}Te_{2.95}Se_{0.05} | zirconia | aluminum foil | 3000 | 3 | 600 | possible |
| 29 | n | Bi_{1.9}Sb_{0.1}Te_{2.95}Se_{0.05} | zirconia | aluminum foil | 3000 | 3 | 600 | possible |
| 30 | n | Bi_{1.99}Sb_{0.01}Te_{2.95}Se_{0.05} | zirconia | aluminum foil | 3000 | 3 | 600 | possible |
| 31 | n | Bi₂Te₃ | zirconia | aluminum foil | 3000 | 3 | 600 | possible |
| 32 | p | Bi₂Te_{2.85}Se_{0.15} | zirconia | aluminum foil | 3000 | 3 | 615 | possible |

### (2) Evaluation of the thermoelectric properties

The thermoelectric properties of the resulting thick film elements were evaluated. The Seebeck coefficient and the electrical conductivity in the direction perpendicular to the direction of thickness of the thick film were measured using a commercial instrument for measuring thermoelectric properties (ZEM apparatus from Ulvac-Riko Incorporated). The results are shown in Table 2.

**[Table 2]**

| | | type | composition | electrical conductivity (S/cm) | Seebeck coefficient (µV/K) | power factor (10⁻³ W/mK²) |
|---|---|---|---|---|---|---|
| present invention | 1 | p | Bi0.5Sb1.5Te3 | 1627 | 161 | 4.22 |
| | 2 | p | Bi1.05b1.0Te3 | 1638 | 141 | 3.26 |
| | 3 | p | Bi1.85b0.2Te3 | 1140 | 171 | 3.33 |
| | 4 | n | Bi1.86b0.2Te2.85Se0.15 | 997 | -175 | 3.05 |
| | 5 | n | Bi1.9Sb0.1Te2.85Se0.15 | 1054 | -184 | 3.57 |
| | 6 | n | Bi1.99Sb0.01Te2.85Se0.15 | 1311 | -157 | 3.23 |
| | 7 | n | Bi1.8Sb0.2Te2.75Se0.25 | 974 | -209 | 4.25 |
| | 8 | n | Bi1.8Sb0.2Te2.95Se0.05 | 1007 | -205 | 4.23 |
| | 9 | n | Bi₂Te₃ | 843 | -146 | 1.80 |
| | 10 | p | Bi₂Te_{2.85}Se_{0.15} | 1010 | 127 | 1.63 |
| prior processes | 11* | n | Bi_{1.8}Sb_{0.2}Te_{2.85}Se_{0.15} | 1234 | -198 | 4.84 |
| | 12** | p | Bi_{0.5}Sb_{1.5}Te₃ | 850 | 220 | 4.11 |

| | | | | | | |
|---|---|---|---|---|---|---|
| * H. Kitagawa et al, Scripta Materialia, Vol 49 (2003) 309-313 ** D. Rowe et al, CRC Handbook of Thermoelectrics, 211-236 | | | | | | |

### (3) The centrifugal acceleration

When the centrifugal acceleration was 0 G, the wettability between the molten material and the substrate was poor and the solidified material (semiconductor) formed a lump and did not form a film. In addition, the solidified material was easily peeled from the substrate.

When a centrifugal acceleration of 100 G was applied to the groove with width 10 mm, the molten material was present uniformly in the processed groove and a good-quality film was formed. In addition, the film was tightly bonded and did not peel from the substrate. The results of compositional analysis on the cross section of the film showed that the composition of the film was uniform.

When a centrifugal acceleration of 1000 G was applied to the groove with width 0.1 mm or more, the molten material was present uniformly in the processed groove and a good-quality film was formed. In addition, the film was tightly bonded and did not peel from the substrate. The results of compositional analysis on the cross section of the film showed that the composition of the film was uniform.

When a centrifugal acceleration of 10000 G was applied to the groove with width 0.001 mm or more, the molten material was present uniformly in the processed groove and a good-quality film was formed. In addition, the film was tightly bonded and did not peel from the substrate. The results of compositional analysis on the cross section of the film showed that the composition of the film was uniform.

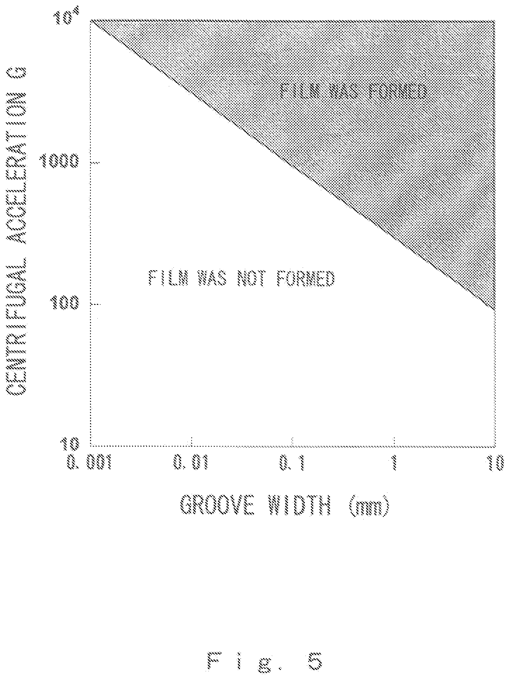

The relationship between the groove width and the centrifugal acceleration at which film was formed or not formed is shown in FIG 5. The centrifugal acceleration for obtaining a satisfactory adhesive strength increases as shown in the figure as the width of the groove declines.

### (4) The heating temperature

When the heating temperature was 585°C or 600°C and the Bi_{0.5}Sb_{1.5}Te₃ powder was employed for the p-type thermoelectric material, a portion of the starting powder melted, but the entire starting powder did not melt and the film obtained had a rough surface. When the heating temperature was 615°C, the starting powder completely melted and a good-quality film was formed.

When the heating temperature was 585°C and the Bi_{1.8}Sb_{0.2}Te_{2.85}Se_{0.15} powder was employed for the n-type thermoelectric material, the entire starting powder did not melt. When the heating temperature was 600°C, the starting powder was completely melted and a good-quality film was formed.

A good-quality film was also formed in a process in which p-type semiconductor and n-type semiconductor were simultaneously produced by adjusting the heating temperature to be suitable for a semiconductor having a higher melting point.

### (5) The substrate

When alumina or zirconia was used for the substrate, there was no reaction between the thermoelectric material and the substrate and a good-quality thermoelectric material film was formed on the substrate.

### (6) Composition at which films having a uniform crystal orientation can be obtained

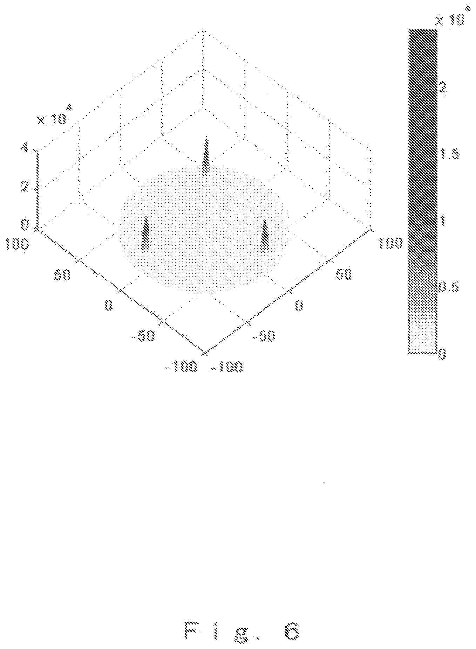

By the addition of at least 0.01 at.% Sb in the p-type and n-type semiconductors, a thick film constituted of crystals oriented in the same direction could be formed in the processed groove in the substrate. The (015) pole figure is shown in FIG 6 for the p-type semiconductor obtained by the process according to the present invention.

The figure demonstrates that a Bi-Te system oriented thick film having a crystal structure with threefold symmetry can be produced. On the other hand, crystal orientation was not obtained in a sample to which Sb had not been added.

### (7) Effect of the lid and sealed vessel

It was shown that volatilization of the readily volatile Te and Se was inhibited during heating by the sealing effect of the lid and sealed vessel. When heating was carried out in the absence of the lid and sealed vessel, the weight of the resulting film was reduced by several tens of wt% from the weight of the starting powder prior to heating. This reduction was due to the volatilization of Te or Se.

The thermoelectric properties in this case were reduced due to a shift in the composition of the thermoelectric material. On the other hand, when a sealed state was set up by the lid and sealed vessel, the weight loss was restrained to not more than 1 wt% and the desired composition was obtained.

As is clear from Table 2, the solidified material (semiconductor) obtained by the process of producing a thermoelectric element of the present invention had a power factor of at least 3.0 (mW/mK²) in all examples in which at least 0.01 at.% Sb was added. This was an excellent value entirely in comparison with that obtained by the prior single crystal growth processes. In addition, a simple and convenient process that does not require post-processing and that provides a better yield than prior production processes was obtained, also a good-quality fine thermoelectric element constituted of crystals oriented in the same direction was obtained.

### INDUSTRIAL APPLICABILITY

As has been described in the preceding, the present invention relates to a process of producing a fine thermoelectric element. The present invention provides a process of producing a fine thermoelectric element that makes possible the construction of an integrated circuit of a fine structure (structural unit of 0.01 to 10 mm) of a thermoelectric material constituted of crystals oriented in the same direction. The present invention is useful for providing a process of producing the previously described fine structure, which has the potential for utilization as a power source such as a ubiquitous power source, as a power source for recovering waste heat, and as a Peltier element.

## Claims

1. A method for producing, on a substrate, a fine thermoelectric element having a structural unit of 0.01 to 10 mm composed of a fine structure of a thermoelectric material constituted of crystals oriented in the same direction,
said method comprising:
charging a required amount of a raw material for the thermoelectric material to a processed groove in a substrate;
placing a lid on the substrate;
enclosing the substrate and lid within a sealed vessel to provide a sealed state;
heating the material at a temperature that is greater than or equal to the melting point of the thermoelectric material and less than its boiling point to cause melting while applying centrifugal force in a direction perpendicular to the direction of the groove bottom of the processed groove, to bring the molten material into tight contact with the processed groove; and
cooling the material to obtain a thermoelectric material constituted of crystals oriented in the same direction.

2. The method for producing a fine thermoelectric element according to claim 1, wherein the raw material composition for the thermoelectric material comprises Bi and Sb as the main components at the A site and Te and/or Se as the main component at the B site in an A₂B₃ intermetallic compound.

3. The method for producing a fine thermoelectric element according to claim 1, wherein a centrifugal acceleration is applied in the range of at least 100 G and not more than 10000 G based on the relationship Y = 316.2X^{-0.5} between the centrifugal acceleration (Y) and the groove width (X) of the processed groove.

4. The method for producing a fine thermoelectric element according to claim 1, wherein a p-type semiconductor and an n-type semiconductor are simultaneously produced by adjusting the heating temperature to be suitable for a semiconductor having a higher melting point.

## Patentansprüche

1. Verfahren zur Herstellung, auf einem Substrat, eines feinen thermoelektrischen Elements mit einer Struktureinheit von 0,01 bis 10 mm, gebildet aus einer Feinstruktur eines thermoelektrischen Materials bestehend aus in dieselbe Richtung ausgerichteten Kristallen,
das Verfahren umfassend:
Laden einer benötigten Menge eines Ausgangsmaterials für das thermoelektrische Material auf eine verarbeitete Rille in einem Substrat;
Platzieren eines Deckels auf dem Substrat;
Einschließen des Substrats und Deckels innerhalb eines abgedichteten Behälters, um einen abgedichteten Zustand bereitzustellen;
Erhitzen des Materials auf eine Temperatur, die größer ist als oder gleich zu dem Schmelzpunkt des thermoelektrischen Materials und geringer als dessen Siedepunkt, um Schmelzen zu bewirken unter Anlegen von Zentrifugalkraft in einer Richtung senkrecht zu der Richtung des Rillenbodens von der verarbeiteten Rille, um das geschmolzene Material in engen Kontakt mit der verarbeiteten Rille zu bringen; und
Abkühlen des Materials, um ein thermoelektrisches Material, gebildet aus in dieselbe Richtung ausgerichteten Kristallen, zu erhalten.

2. Verfahren zur Herstellung eines feinen thermoelektrischen Elements nach Anspruch 1, wobei die Ausgangsmaterialszusammensetzung für das thermoelektrische Material Bi und Sb als die Hauptbestandteile an der A Stelle und Te und/oder Se als den Hauptbestandteil an der B Stelle in einer A₂B₃ intermetallischen Verbindung umfasst.

3. Verfahren zur Herstellung eines feinen thermoelektrischen Elements nach Anspruch 1, wobei eine Zentrifugalbeschleunigung in dem Bereich von mindestens 100 G und nicht mehr als 10000 G aufgebracht wird, basierend auf der Beziehung Y = 316,2X^{0.5} zwischen der Zentrifugalbeschleunigung (Y) und der Rillenbreite (X) von der verarbeiteten Rille.

4. Verfahren zur Herstellung eines feinen thermoelektrischen Elements nach Anspruch 1, wobei ein p-Typ-Halbleiter und ein n-Typ-Halbleiter gleichzeitig hergestellt werden durch Einstellen der Heiztemperatur als geeignet für einen Halbleiter mit einem höheren Schmelzpunkt.

## Revendications

1. Procédé pour fabriquer, sur un substrat, un élément thermoélectrique fin ayant une unité structurale de 0,01 à 10 mm composée d'une structure fine de matériau thermoélectrique constitué de cristaux orientés dans la même direction,
ledit procédé comportant :
le chargement, dans une gorge traitée ménagée dans un substrat, d'une quantité requise de matière première pour le matériau thermoélectrique ;
la mise en place d'un couvercle sur le substrat ;
l'enfermement du substrat et du couvercle dans un boîtier étanche pour créer une étanchéité ;
le chauffage du matériau à une température supérieure ou égale au point de fusion du matériau thermoélectrique et inférieure à son point d'ébullition pour provoquer une fusion tout en appliquant une force centrifuge dans une direction perpendiculaire à l'orientation du fond de la gorge traitée, afin de faire venir le matériau en fusion parfaitement au contact de la gorge traitée ; et
le refroidissement du matériau pour obtenir un matériau thermoélectrique constitué de cristaux orientés dans la même direction.

2. Procédé pour fabriquer un élément thermoélectrique fin selon la revendication 1, dans lequel la composition de la matière première pour le matériau thermoélectrique comprend Bi et Sb comme principaux constituants sur le site A et Te et/ou Se comme principal constituant/principaux constituants sur le site B dans un composé intermétallique A₂B₃.

3. Procédé pour fabriquer un élément thermoélectrique fin selon la revendication 1, dans lequel est appliquée une accélération centrifuge d'au moins 100 G et non supérieure à 10 000 G sur la base de la relation Y = 316,2 X^{-0.5} entre l'accélération centrifuge (Y) et la largeur (X) de la gorge traitée.

4. Procédé pour fabriquer un élément thermoélectrique fin selon la revendication 1, dans lequel un semiconducteur de type P et un semiconducteur de type N sont produits simultanément grâce à un réglage de la température de chauffage afin qu'elle convienne pour un semiconducteur à point de fusion plus haut.
